# EUROPEAN PATENT APPLICATION

(11) **EP 4 838 117 A1**
(43) Date of publication of application: **11.11.2026**
(21) Application number: 25174170.8
(22) Date of filing: 05.05.2025
(51) Int. Cl.: F16K 7/12

(54) **VALVE ASSEMBLY WITH THERMAL COMPENSATION**

(71) Applicant: Dätwyler Schweiz AG, 6467 Schattdorf (CH)
(72) Inventor: Düring, Lukas, 9545 Wängi (CH)
(74) Representative: Prins Intellectual Property AG

(57) **Abstract**

A valve assembly comprising a rigid valve body (3), and a stacked dielectric elastomer actuator (2), wherein the valve body (3) comprises a valve chamber (31) with a fluid inlet (32), a fluid outlet (33) and a valve seat (34) separating the fluid inlet (32) from the fluid outlet (33); wherein the stacked dielectric elastomer actuator (2) comprises a valve-actuating end (21), a non-actuating end (22) opposite the valve-actuating end (21), an inner active section (23) reaching from the valve-actuating end (21) to the non-actuating end (22) and forming an actuatable surface (24) at the valve-actuating end (21), and a peripheral non-actuatable passive section (25) laterally surrounding the inner active section (23); wherein the valve body (3) comprises a bonding surface (35) surrounding the valve chamber (31) and is bonded with the bonding surface (35) to the outer passive section (25) to close and seal the valve chamber (31) such that in an inactive state of the stacked dielectric elastomer actuator (2) the actuatable surface (24) of the active section (23) seals against the valve seat (34); wherein the peripheral non-actuatable passive section (25) forms a load-bearing housing around the active section (23) allowing the actuatable surface (24) to cave in upon activation of the stacked dielectric elastomer actuator (2) and thereby to retract from the valve seat (34); wherein the non-actuating end (22) of the stacked dielectric elastomer actuator (2) is a free-floating end, which is movable while the passive section (25) and the active section (23) exhibit the same thermal expansion or contraction upon changes in temperature.

## Description

### Technical Field

The invention relates to a valve assembly including valve body and a stacked dielectric elastomer actuator (SDEA) for controlling the valve.

### Technical Background

An actuator is a component of a machine that produces force, torque, or displacement, usually in a controlled way, when an electrical, pneumatic or hydraulic input is supplied to it in a system (called an actuating or actuator system). An actuator converts such an input signal into the required form of mechanical energy. Electro-mechanical actuators converting electrical energy into mechanical force are also called transducer. Electro-mechanical actuators are for example solenoids, piezoelectric devices, or electroactive polymers (EAP).

Dielectric elastomers actuators (DEA) are a class of electroactive polymers (EAP), which principle of work is based on the compression of an elastomeric film sandwiched between two compliant electrodes. When a voltage is applied to the electrodes, the arising electric field causes a decrease in thickness and increase in area of the elastomeric film. The elastomer film moves back to its original position when the electrodes are short-circuited. DEA can transform electric energy into mechanical work and vice versa. In a so-called stacked (or multi-layered) dielectric elastomer actuator (SDEA) a plurality of dielectric and electrode layers are alternately stacked to increase the actuation stroke length. Such stacks may comprise dozens or hundreds of layers. The actuating direction (or longitudinal direction) of the SDEA is then perpendicular to the stacked layers.

SDEAs constitute an excellent alternative to conventional actuator technologies such as DC motors, solenoid electromagnets, magnetic technologies and piezoelectric systems. Stacked dielectric elastomer actuators provide a lightweight, compact, noiseless and easy to assemble solution with low complexity (no need of gears), low maintenance and high lifetime.

DE102018218637 describes a control valve device comprising a valve housing with a fluid inlet duct, a fluid outlet duct and a valve seat. A stacked dielectric elastomer actuator is arranged in and fastened to the valve housing of the control valve device by way of a first end section. A second end section opposite the first end section is provided with a closure element which lies opposite the valve seat. By operating the SDEA, a stroke movement of the closure element relative to the valve seat can be caused to selectively open or close the valve channel and effect the passage of a fluid.

Due to the nature of the elastomeric material used in SDEAs, they intrinsically possess non-negligible thermal expansion which means that the actuator will exhibit different initial lengths as a function of temperature. This thermal behaviour is particularly relevant for valves, where precise strokes must be ensured across a broad range of temperatures.

In particular, current valve designs, as known e.g. from DE102018218637, use an active longitudinal contraction of the actuator to open and a passive longitudinal expansion to close the valve. The distance between an actuator baseplate and a valve seat or nozzle is fixed by the valve housing. Because the actuator expands at increasing temperatures and contracts at decreasing temperatures more than the valve housing does, the activated actuator is too long to open the valve at high temperatures, while the passivated actuator is too short to close the valve at low temperatures.

A similar design is known from DE102013009592 describing a pumping device based on several SDEAs. Again, the SDEA is firmly arranged between a carrier board providing electric connections of the SDEAs and a stationary boundary wall with inlets and outlets. Thermal expansion or contraction of the SDEA may lead to disfunction of the device.

Thus, for some applications, in particular valves, there is a need to compensate for the intrinsic thermal behaviour of SDEAs.

WO2005053045 addresses a similar problem of electro-mechanical actuator based on a piezoelectric ceramic multilayer actuator (piezoelectric CMA) and describes an actuator assembly including the piezoelectric CMA and a rigid, non-flexing support structure for the piezoelectric CMA. Part of the material of the rigid, non-flexing, support structure may be replaced with an element made from a material with a coefficient of thermal expansion (CTE) capable of compensating for the thermal expansion mismatch between the materials of the support structure and the piezoelectric CMA. Thus, some parts of the rigid, non-flexing support structure have larger CTE than the piezoelectric CMA and some parts have a lower CTE than the piezoelectric CMA.

US5205147 provides a similar solution for a piezoelectric actuator. A case around the piezoelectric element is formed with two kinds of material, one having a lower CTE and the other having a higher CTE than that of the piezoelectric element.

US6313568 describes a piezoelectric actuator assembly that is insensitive to wide variation in operating temperatures. The assembly includes a stack of piezoelectric devices and a surrounding housing assembly formed of an outer cylindrical housing portion formed of steel having a coefficient of thermal expansion above that of the piezoelectric material and an inner cylindrical housing portion formed of Si-Ni ceramic. By arranging the inner and outer housing portions in parallel and forming the housing portions with appropriate cross-sectional areas, the housing assembly will have an effective coefficient of thermal expansion that is equivalent to that of the piezoelectric element.

US4284263 describes a control valve having the actuating member supported within a housing. The actuating member includes an elongated piezoelectric element having a relatively low thermal coefficient of expansion. The housing is made from common, inexpensive materials having moderately higher thermal coefficient of expansion, and the actuating member includes a spacer having a high thermal coefficient of expansion, arranged between the closed housing end and the piezoelectric element. By proper dimensioning of the spacer and housing with respect to the piezoelectric element, temperature compensation may be achieved without the use of exotic materials.

### Summary of the Invention

It is an objective of the invention to provide a valve assembly with a stacked dielectric elastomer actuator that functions correctly over large temperature changes of more than 40°C (or over a large temperature range covering a range from below 0°C to above 40°C). It is a further objective to provide a stacked dielectric elastomer actuator or a compact valve design suitable for pneumatic low-pressure valves and applicable to an efficient manufacturing process.

At least one of the objectives of the present invention is achieved by a valve assembly according to claim 1. Further embodiments of the invention are set forth in the dependent claims.

The valve assembly comprises a rigid valve body and a stacked dielectric elastomer actuator (SDEA). The valve body comprises a valve chamber with a fluid inlet, a fluid outlet and a valve seat separating the fluid inlet from the fluid outlet. The stacked dielectric elastomer actuator comprises a valve-actuating end, a non-actuating end opposite the valve-actuating end, an inner active section reaching from the valve-actuating end to the non-actuating end and forming an actuatable surface at the valve-actuating end, and a peripheral non-actuatable passive section laterally surrounding the inner active section. The valve body comprises a bonding surface surrounding the valve chamber and is bonded with the bonding surface to the outer passive section to close and seal the valve chamber such that in an inactive state of the stacked dielectric elastomer actuator the actuatable surface of the active section seals against the valve seat. The peripheral non-actuatable passive section forms a load-bearing housing around the active section allowing the actuatable surface to cave in upon activation of the stacked dielectric elastomer actuator and thereby to retract from the valve seat. The non-actuating end of the stacked dielectric elastomer actuator is a free-floating end, which is movable while the passive section and the active section exhibit the same thermal expansion or contraction upon changes in temperature.

Thus, the present invention describes a compact valve design in which the thermal expansion of the SDEA has no influence on the function of the valve. The passive section forming a load-bearing housing around the active section is firmly connected to the inner active section and made of the same elastomeric material and therefore exhibits the same thermal expansion or contraction over a large temperature range. Because the free-floating end of the SDEA is not mechanically connected to or supported by the valve body other than the stacked dielectric elastomer actuator itself, it can freely move upon any changes in temperature, without having any effect on the ability to switch between an active/open state and an inactive/closed state. In other words, the distance between the non-actuatable end of the SDEA and the valve seat adapts to temperature changes, whereas the distance between the actuatable surface and the valve seat does not change upon temperature changes. Thus, the SDEA can expand or contract thermally in the longitudinal direction (or actuating direction) without restriction and the valve can be operated in a large temperature range of -40°C to 120°C or more.

SDEAs typically comprise a stack of dielectric elastomer layers, first inner electrode layers and second inner electrode layers, wherein the first inner electrode layers and the second inner electrode layers are alternatingly arranged between the dielectric elastomer layers. The SDEA defines an actuating direction perpendicular to the inner electrode layers and the elastomer layers. Such SDEAs may be efficiently manufactured by stacking these layers on top of each other, while first and second inner electrode layers are applied in specific regions only. Different manufacturing methods are known. Typically, the outermost layer at the valve-actuating end of the stacked dielectric elastomer actuator is an elastomer layer.

The inner active section comprises the first inner electrode layers and the second inner electrode layers, and the passive section is lacking the first inner electrode layers and/or second inner electrode layers. Thus, the SDEA of the valve assembly can adopt an active state for opening the valve and an inactive state for closing the valve. In the active state, a voltage is applied to the first and second inner electrode layers leading to a contraction of the inner active section. The actuatable surface of the inner active section caves in with the highest displacement in the centre of the actuatable surface and thereby retracts from the valve seat. The valve is open, and fluid may flow from the inlet to the outlet. In the inactive state, no voltage is applied and the actuatable surface elastically returns to the original position sealing against the valve seat. The valve is closed.

In the active state, the passive section, which comprises only one of the first and second inner electrode layers or no electrode layer at all does not react to the application of a voltage. The passive section however forms a load-bearing housing large and stable enough to prevent a contraction of the entire stacked dielectric elastomer actuator including the passive section. It is therefore not necessary to attach the non-actuating end of the SDEA to a support structure of the valve assembly to fix the relative position of the non-actuating end of the SDEA, which is the case in the known valve designs. Such a fixation would lead to malfunction of the valve upon large temperature changes.

The electrode layers are very thin, have a much lower coefficient of thermal expansion (CTE) than the elastomer. Their contribution to the thermal expansion or contraction of the SDEA can be neglected. In other words, the thermal expansion or contraction of the active and passive sections are the same.

The housing formed by the passive section may however be flexible enough to compensate for a lateral expansion of the inner active section upon activation. Thus, it may be able to slightly bulk outwards.

In some embodiments, the stacked dielectric elastomer actuator comprises a first feedline (also known as first outer electrode) arranged on a first lateral surface of the stack and a second feedline (also known as second outer electrode) arranged on a second lateral surface of the stack, wherein the first inner electrode layers extend through the passive section to the first feedline and the second inner electrode layers extend through the passive section to the second feedline. Such an SDEA may be efficiently manufactured by applying the electrode layers in the required sections. The first and second feedlines are a layer of an elastic, electrically conductive polymeric material, which is applied to the lateral sides of the stack. The first and second feedlines may be electrically connected in a manner to not hinder the free-floating non-actuating end from moving upon temperature changes.

In some embodiments, the first feedline arranged on the first lateral surface of the stack is opposite the second feedline arranged on the second lateral surface of the stack.

In some embodiments, the elastomer layers may be slightly thicker in the peripheral non-actuatable passive section than in the inner active section to compensate for the missing first and/or second inner electrode layers.

In some embodiments, the first feedline and the second feedline may be electrically contacted at the non-actuating end of the stacked dielectric elastomer actuator or via electrical contacts on the valve body. The stacked dielectric elastomer actuator may comprise a rigid end plate at the free-floating non-actuating end comprising electrically conductive connecting pads. The pads may be contacted by flexible wires, which allow the non-actuating end to freely move upon temperature changes. Alternatively, the feedlines may be contacted at the valve-actuating end via electrically conductive connecting pads on the valve body.

In some embodiments, the volume of the passive section may be at least the volume of the active section. The lateral thickness of the passive section may be chosen to provide sufficient support to prevent contraction of the passive section upon activation of the SDEA. The lateral thickness of the passive section may be the same on all sides of the SDEA to provide a load-bearing housing. Alternatively, lateral thickness of the passive section may be larger on two opposite sides compared to the other sides as long as the surrounding bonding surface is large enough to provide a strong bond with the valve body. In this case, the larger passive sections on opposite sides mainly form the load-bearing part of the housing.

In some embodiments, the bonding between the bonding surface of the valve body and the passive section is a chemical bonding. The chemical bonding may be achieved by an adhesive layer or by choosing suitable materials for the valve body to form covalent bonds with the outermost elastomer layer of the stack. The outermost layer at the valve-actuating end may be an elastomer layer and may form a planar surface at the valve-actuating end of the SDEA for bonding to the planar bonding surface of the valve body.

In some embodiments, the valve assembly further comprises a rigid end plate bonded to the active section and the passive section at the non-actuating end of the stacked dielectric elastomer actuator. The bonding may be achieved the same way as described above. The rigid end plate prevents caving in of the inner active section at the non-actuating end thereby enhancing the displacement of the actuatable surface on the valve-actuating side. Alternatively, the non-actuatable end of the stack may comprise several elastomer layers without intermediate electrode layers. Thus, the stack may comprise a further passive non-actuatable region at the non-actuatable end of the stack.

In some embodiments, the cross-section of the valve chamber may correspond to the surface area of the inner active section at the valve-actuating end of the stacked dielectric elastomer actuator.

In some embodiments, the valve seat may protrude longitudinally in actuating direction over the bonding surface of the valve body. The protruding valve seat is pressed against the elastomeric actuatable surface and creates a tight seal.

The valve seat may be a bar extending over the entire width of the valve chamber dividing the valve chamber in an inlet chamber and an outlet chamber. Such a bar-like valve seat is arranged centrally and optimizes a flow cross-section in the open state of the valve. The bar may extend into the passive section. Alternatively, the valve seat may be a hollow cylinder extending from the fluid inlet or fluid outlet and arranged centrally in the valve chamber.

In some embodiments, the valve body may be made of a rigid, electrically non-conductive thermoplast. The valve body is preferably manufactured by injection moulding.

In some embodiments, the valve assembly may be a low-pressure pneumatic valve. Such valves may be used for application such as low-pressure automation, e.g. in semiconductor manufacturing/handling, robotic applications, low-pressure medical devices, or low-pressure analytic devices (e.g. gas chromatography).

Depending on the application of the valve assembly, the fluid inlet and outlet may be attached to fluid conducts or a larger fluid manifold, which are often larger non-flexible or even fixed structures. By attaching the valve assembly via the valve body only the non-actuating end of the stacked dielectric elastomer actuator remains free-floating and can compensate for any thermal expansion or contraction. The valve assembly may be placed in a larger housing as long as the free-floating end does not abut to any part of the housing.

The invention further refers to a stacked dielectric elastomer actuator for a valve assembly as described above. The stacked dielectric elastomer actuator comprises an inner active section forming an actuatable surface and a peripheral non-actuatable passive section laterally surrounding the inner active section and forming a load-bearing housing around the active section. The stacked dielectric elastomer actuator comprises a stack of dielectric elastomer layers, first inner electrode layers and second inner electrode layers, wherein the first inner electrode layers and second inner electrode layers are alternatingly arranged between the dielectric elastomer layers. The inner active section comprises the first inner electrode layers and the second inner electrode layers, and the passive section is lacking the first inner electrode layers and/or second inner electrode layers. The stacked dielectric elastomer actuator comprises a first feedline arranged on a first lateral surface of the stack and a second feedline arranged on a second lateral surface of the stack, wherein the first inner electrode layers extend through the passive section to the first feedline and the second inner electrode layers extend through the passive section to the second feedline.

In some embodiments the stacked dielectric elastomer actuator may comprise a rigid end plate arranged parallel to the layers at one of the ends.

In some embodiments, the volume of the passive section may be at least the volume of the active section. The lateral thickness of the passive section may be chosen to provide sufficient support to prevent contraction of the passive section upon activation of the SDEA.

The valve design with the above-described valve body, the stacked dielectric elastomer actuator with the extending first and second inner electrodes forming large inactive sections or the contacting of the feedlines via the valve body may also be seen as separate independent inventions.

### Brief Explanation of the Figures

The invention is described in greater detail below with reference to embodiments that are illustrated in the figures. The figures show:
- Fig. 1: a perspective and exploded view of a valve assembly;
- Fig. 2: a perspective and exploded view of the valve assembly of Fig.1;
- Fig. 3: a top view of the valve assembly of Fig. 1;
- Fig. 4: a sectional view of the valve assembly of Fig. 1 in the inactive/closed state;
- Fig. 5: a sectional view of the valve assembly of Fig. 1 in the active/open state;
- Fig. 6: a perspective view of another variant of a valve assembly;
- Fig. 7: a perspective view of the valve assembly of Fig. 6;
- Fig. 8: a perspective view of another type of valve seat;
- Fig. 9: a sectional view of the layering of an SDEA with active and inactive sections.

### Embodiments of the Invention

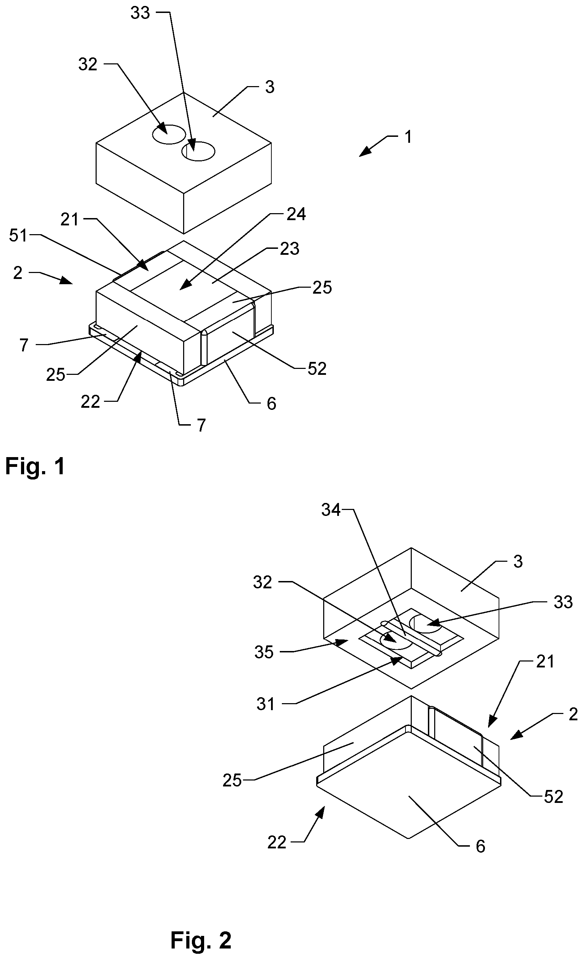

Figures 1 to 5 show a first variant of a valve assembly 1 comprising a valve body 3 and a stacked dielectric elastomer actuator 2 (SDEA). The SDEA 2 defines an actuating direction A perpendicular to the several layers of the SDEA. The valve body 3, typically made of rigid thermoplastic material e.g. by injection-moulding, comprises a valve chamber 31 with a fluid inlet 32 and a fluid outlet 33 - as can be seen in the perspective, exploded views of Figs 1 and 2. The valve chamber 31 is a recess at a bottom surface of the valve body 3 facing the SDEA 2 (see Fig. 2). The valve body 3 further comprises a valve seat 34 separating the fluid inlet 32 from the fluid outlet 33. In the shown embodiment the valve seat 34 is a bar centrally arranged between the fluid inlet 32 and the fluid outlet 33 and extending over the entire width of the valve chamber 31.

The valve chamber is surrounded by a bonding surface 35 of the valve body 31 for bonding the valve body 3 to the SDEA 2 as explained further below. The valve seat 34 protrudes longitudinally in actuating direction A over the bonding surface 35 of the valve body 3 to form a tight seal with the SDEA 2 in an inactive/closed state of the valve assembly 1. The bar-like valve seat 34 extends into the bonding surface 35 on both sides of the valve chamber 31.

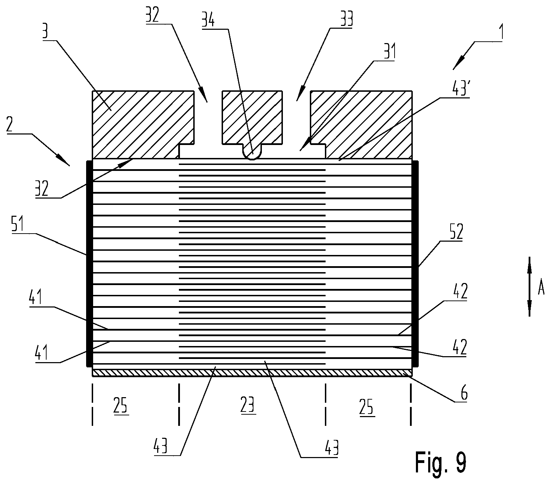

The SDEA 2 (also shown in Fig. 9) comprises a stack of dielectric elastomer layers 43, 43', first inner electrode layers 41 and second inner electrode layers 42, wherein the first inner electrode layers 41 and the second inner electrode layers 42 are alternatingly arranged between the dielectric elastomer layers 43, 43'. The SDEA defines an actuating direction A perpendicular to the inner electrode layers 41, 42 and the elastomer layers 43, 43'. Such SDEAs may be efficiently manufactured by stacking these layers on top of each other, while first and second inner electrode layers are applied in specific regions only. Different manufacturing methods are known. Typically, the outermost layer 43' at the valve-actuating end of the stacked dielectric elastomer actuator is an elastomer layer.

The SDEA further comprises a valve-actuating end 21 facing the valve body 3 and a non-actuating end 22 opposite the valve-actuating end 21. An inner active section 23 reaching from the valve-actuating end 21 to the non-actuating end 22 is formed by stacking elastomer layers 43, 43', first inner electrode layers 41 and second inner electrode layers 42. The inner active section 23 forms an actuatable surface 24 at the valve-actuating end 21. The SDEA further comprises a peripheral non-actuatable passive section 25 laterally surrounding the inner active section 23. The passive section 25, which may be formed by stacking elastomer layers 43, 43' during the same stacking process as for forming the active section 23, lacks at least the first inner electrode layer 41 or the second inner electrode layer 42. In Figs. 1, 4 and 5 the different active and passive sections are separated by lines. Such lines may not be visible on the SDEA, e.g. when the outermost layer 43' is an elastomer layer.

For electrically connecting the first and second inner electrode layers 41, 42, the SDEA comprises a first feedline 51 arranged on a first lateral surface of the stack and a second feedline 52 arranged on a second lateral surface of the stack opposite the first feedline 51. The first inner electrode layers 41 extend through the passive section 25 to the first feedline 51 and the second inner electrode layers 42 extend through the passive section 25 to the second feedline 52 (see Fig. 9). Such an SDEA 2 may be efficiently manufactured by applying the inner electrode layers 41, 42 in the required sections. The other parts of the passive section do not have inner electrode layers 41, 42.

The first and second feedlines 51, 52 are a layer of an elastic, electrically conductive polymeric material, which is applied to the lateral sides of the stack. In the shown embodiment, the first and second feedlines 51, 52 are electrically connected to separate electrically conductive contact pads 7.

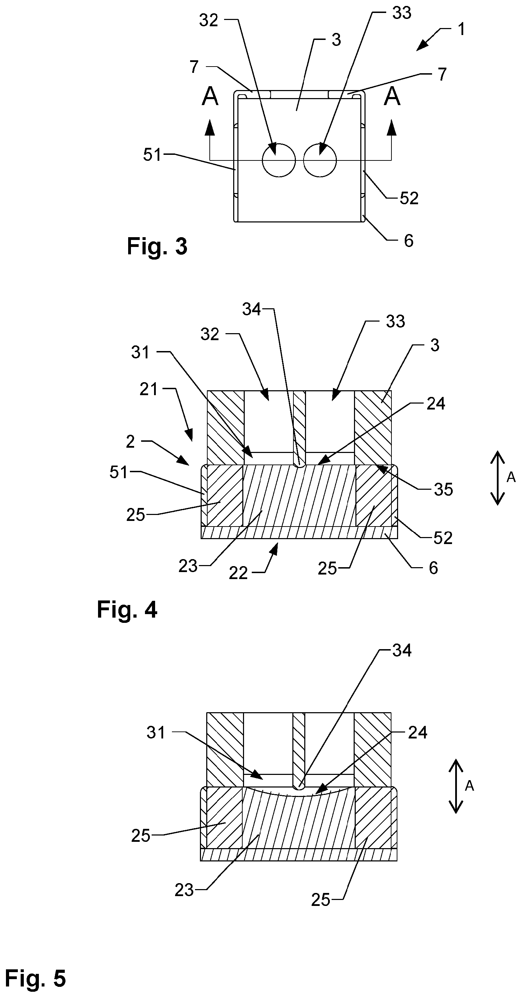

Figs 4 and 5 show the valve assembly in an inactive/closed state (Fig. 4) and an active/open state (Fig. 5). The valve body 3 and the SDEA 2 are attached to each other by bonding the passive section 25 of the SDEA 2 to the bonding surface 35 of the valve body 3. By bonding the bonding surface 35 to the outer passive section 25, the valve chamber 31 is closed and sealed such that in an inactive state of the SDEA 2 the actuatable surface 24 of the active section 23 seals against the valve seat 34 (see Fig. 4). The slightly protruding valve seat 34 creates a tight seal as it is pressed against the elastomeric stack.

The bonding between the bonding surface 35 of the valve body 31 and the passive section 25 of the SDEA 2 typically is a chemical bonding. The chemical bonding may be achieved by an adhesive layer or by choosing suitable materials for the valve body 31 to form covalent bonds with the outermost elastomer layer 43' of the SDEA 2. A bonding surface 35 limited by the recess of the valve chamber 31 reduces the risk of adhesive flowing towards the active section 23 and thereby also bonding the active section 23 to the valve body 31.

The cross-section of the valve chamber 31 corresponds to the surface area of the actuatable surface 24 of the inner active section 23 of the SDEA 2.

The inner active section 23 comprises the first inner electrode layers 41 and the second inner electrode layers 42, and the passive sections 25 are lacking the first inner electrode layers 41 and/or second inner electrode layers 42. Thus, the SDEA 2 of the valve assembly 1 can adopt an active state for opening the valve and an inactive state for closing the valve. In the active state (Fig. 5), a voltage is applied to the first and second inner electrode layers 41, 42 leading to a contraction of the inner active section 23. The actuatable surface 24 of the inner active section 23 caves in with the highest displacement in the centre of the actuatable surface 24 and thereby retracts from the valve seat 34. The valve is open, and fluid may flow from the inlet 32 to the outlet 33. In the inactive state (Fig. 4), no voltage is applied and the actuatable surface 24 elastically returns to the original position sealing against the valve seat 34. The valve is closed.

In the embodiment of Figs. 1 to 5, the valve assembly further comprises a rigid end plate 6, which is bonded to the active section 23 and the passive section 25 at the non-actuating side 22 of the SDEA 2. The contact pads 7 are arranged on the end plate 6 for contacting with flexible wires, which may be soldered to the pads 7. Thus, the first and second feedlines 51, 52 may be electrically connected in a manner to not hinder the free-floating non-actuating end 22 from moving upon temperature changes.

The fluid inlet 32 and outlet 33 may be attached to fluid conducts or a larger fluid manifold, which are typically larger non-flexible and fixed structures. The valve body 31 is thus a fixed structure. The non-actuating end 22 of the SDEA 2 is a free-floating end, which is movable while the passive section 25 and the active section 23 exhibit the same thermal expansion or contraction upon changes in temperature. This is possible, because the peripheral non-actuatable passive section 25 forms a load-bearing housing around the active section 23 allowing the actuatable surface 24 to cave in upon activation of the SDEA 2, while at the same time preventing a contraction of the entire SDEA 2 including the passive section 25.

The outer passive section 25 forming the load-bearing housing around the inner active section 23 is firmly connected to the inner active section 23 and made of the same elastomeric material and therefore exhibits the same thermal expansion or contraction over a large temperature range. Because the free-floating end 22 of the SDEA 2 is not mechanically connected to or supported by the valve body 3 other than the SDEA 2 itself, it can freely move upon any changes in temperature, without having any effect on the ability to switch between an active/open state and an inactive/closed state. In other words, the distance between the non-actuatable end 22 of the SDEA 2 and the valve seat 34 adapts to temperature changes, whereas the distance between the actuatable surface 24 and the valve seat 34 does not change upon temperature changes. Thus, the SDEA 2 can expand or contract thermally in the longitudinal direction without restriction and the valve can be operated in a large temperature range of -40°C to 120°C or more.

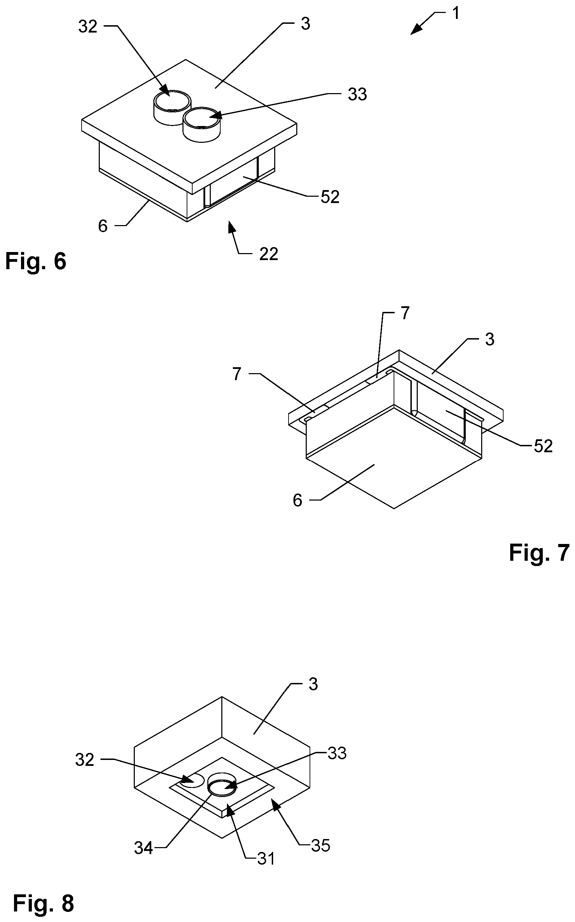

Figs 6 and 7 show another embodiment of a valve assembly 1. The valve assembly 1 of Figs 6 and 7 differs from the valve assembly of Fig. 1 in that the feedlines 51, 52 are connected to conductive pads 7 arranged at the valve body 3. The non-actuating end 22 is provided with a rigid end plate 6 without conductive pads 7. Thus, the electric connections are arranged on the fixed valve body 31 and flexible wires for contacting the feedlines from the free-floating end are not required. In the shown embodiment the valve body 3 is also thinner and the fluid inlet and outlet 32, 33 are protruding ports for connecting fluid conducts.

Fig. 8 shows a variant of the valve body 3 which differs from the valve body 3 of Fig. 2 in that the valve seat 34 is a hollow cylinder extending from the fluid inlet 32 or fluid outlet 33 and is arranged centrally in the valve chamber 31. The valve seat 34 also protrudes over the bonding surface 35.

Fig. 9 shows a cross-section of an SDEA with first and second inner electrode layers 41, 42 extending to lateral first and second feedlines 51, 52 - as explained above.

### Reference Signs

- 1: Valve assembly
- 2: stacked dielectric elastomer actuator (SDEA)
- 21: valve-actuating end
- 22: non-actuating end
- 23: inner active section
- 24: actuatable surface
- 25: peripheral non-actuatable passive section
- 3: valve body
- 31: valve chamber
- 32: fluid inlet
- 33: fluid outlet
- 34: valve seat
- 35: bonding surface
- 41: first electrode layer
- 42: second electrode layer
- 43, 43': elastomer layer
- 51: first feedline
- 52: second feedline
- 6: rigid end plate
- 7: conductive pad
- A: actuating direction

## Claims

1. Valve assembly (1) comprising
a rigid valve body (3), and
a stacked dielectric elastomer actuator (2),
wherein the valve body (3) comprises a valve chamber (31) with a fluid inlet (32), a fluid outlet (33) and a valve seat (34) separating the fluid inlet (32) from the fluid outlet (33);
wherein the stacked dielectric elastomer actuator (2) comprises a valve-actuating end (21), a non-actuating end (22) opposite the valve-actuating end (21), an inner active section (23) reaching from the valve-actuating end (21) to the non-actuating end (22) and forming an actuatable surface (24) at the valve-actuating end (21), and a peripheral non-actuatable passive section (25) laterally surrounding the inner active section (23);
wherein the valve body (3) comprises a bonding surface (35) surrounding the valve chamber (31) and is bonded with the bonding surface (35) to the outer passive section (25) to close and seal the valve chamber (31) such that in an inactive state of the stacked dielectric elastomer actuator (2) the actuatable surface (24) of the active section (23) seals against the valve seat (34);
wherein the peripheral non-actuatable passive section (25) forms a load-bearing housing around the active section (23) allowing the actuatable surface (24) to cave in upon activation of the stacked dielectric elastomer actuator (2) and thereby to retract from the valve seat (34);
wherein the non-actuating end (22) of the stacked dielectric elastomer actuator (2) is a free-floating end, which is movable while the passive section (25) and the active section (23) exhibit the same thermal expansion or contraction upon changes in temperature.

2. Valve assembly (1) according to claim 1, wherein the stacked dielectric elastomer actuator (2) comprises a stack of dielectric elastomer layers (43, 43'), first inner electrode layers (41) and second inner electrode layers (42), wherein the first inner electrode layers (41) and second inner electrode layers (42) are alternatingly arranged between the dielectric elastomer layers (43, 43').

3. Valve assembly (1) according to claim 2, wherein the inner active section comprises the first inner electrode layers (41) and the second inner electrode layers (42), and the passive section is lacking the first inner electrode layers (41) and/or second inner electrode layers (42).

4. Valve assembly (1) according to claim 2 or 3, wherein the stacked dielectric elastomer actuator (2) comprises a first feedline (51) arranged on a first lateral surface of the stack and a second feedline (52) arranged on a second lateral surface of the stack, wherein the first inner electrode layers (41) extend through the passive section (25) to the first feedline (51) and the second inner electrode layers (42) extend through the passive section (25) to the second feedline (52).

5. Valve assembly (1) according to claim 4, wherein the first feedline (51) arranged on the first lateral surface of the stack is opposite the second feedline (52) arranged on the second lateral surface of the stack first lateral surface of the stack.

6. Valve assembly (1) according to claim 4, wherein the first feedline (51) and the second feedline (52) are electrically contacted at the free-floating end of the stacked dielectric elastomer actuator (2) or via electrical contacts on the valve body (3).

7. Valve assembly (1) according to one of the preceding claims, wherein the volume of the passive section (25) is at least the volume of the active section (23).

8. Valve assembly (1) according to one of the preceding claims, wherein the bonding between the bonding surface (35) of the valve body (3) and the passive section (25) is a chemical bonding.

9. Valve assembly (1) according to one of the preceding claims, wherein the valve assembly (1) further comprises a rigid end plate (6) bonded to the active section (23) and the passive section (25) at the non-actuating end (22) of the stacked dielectric elastomer actuator (2).

10. Valve assembly (1) according to one of the preceding claims, wherein the cross-section of the valve chamber (31) corresponds to the surface area of the inner active section (23) at the valve-actuating end (21) of the stacked dielectric elastomer actuator (2).

11. Valve assembly (1) according to one of the preceding claims, wherein the valve seat (34) protrudes over the bonding surface (35) of the valve body (31).

12. Valve assembly (1) according to one of the preceding claims, wherein the valve seat (34) is a bar extending over the entire width of the valve chamber (31) dividing the valve chamber (31) in an inlet chamber and an outlet chamber.

13. Valve assembly (1) according to one of claims 1 to 10, wherein the valve seat (34) is a hollow cylinder extending from the fluid inlet (32) or fluid outlet (33) and arranged centrally in the valve chamber (31).

14. Valve assembly (1) according to one of the preceding claims, wherein the valve assembly is a low-pressure pneumatic valve.

15. Stacked dielectric elastomer actuator (2) for a valve assembly according to one of the preceding claims, comprising an inner active section (23) forming an actuatable surface (24) and a peripheral non-actuatable passive section (25) laterally surrounding the inner active section (23) and forming a load-bearing housing around the active section (23); wherein the stacked dielectric elastomer actuator (2) comprises a stack of dielectric elastomer layers (43, 43'), first inner electrode layers (41) and second inner electrode layers (42), wherein the first inner electrode layers (41) and second inner electrode layers (42) are alternatingly arranged between the dielectric elastomer layers (43, 43'); wherein the inner active section comprises the first inner electrode layers (41) and the second inner electrode layers (42), and the passive section is lacking the first inner electrode layers (41) and/or second inner electrode layers (42); and wherein the stacked dielectric elastomer actuator (2) comprises a first feedline (51) arranged on a first lateral surface of the stack and a second feedline (52) arranged on a second lateral surface of the stack, wherein the first inner electrode layers (41) extend through the passive section (25) to the first feedline (51) and the second inner electrode layers (42) extend through the passive section (25) to the second feedline (52).
